Europäisches Patentamt

European Patent Office

Office européen des brevets

(11) Publication number : **0 502 807 A2**

# EUROPEAN PATENT APPLICATION

(21) Application number : **92610014.0**

(22) Date of filing : **05.03.92**

(51) Int. Cl.[5] : **G01N 27/02**

(30) Priority : **05.03.91 DK 388/91**

(43) Date of publication of application :
**09.09.92 Bulletin 92/37**

(84) Designated Contracting States :
**AT BE CH DE ES FR GB IT LI NL PT SE**

(71) Applicant : **FORCE INSTITUTTERNE**
**345, Park Allè**
**DK-2605 Broendby Strand (DK)**

(72) Inventor : **Northeved, Allan**
**56, Skovbakken**
**DK-3520 Farum (DK)**
Inventor : **Fabrin, Knud**
**7, Klintebakken**
**DK-3520 Farum (DK)**

(74) Representative : **Siiger, Joergen et al**
**c/o Chas. Hude H.C. Andersens Boulevard 33**
**DK-1553 Copenhagen V (DK)**

(54) **A method and a device for measuring the conductance of a fluid.**

(57)    The present invention employs a pipe (2) of an insulating material, which can be inserted in an existing pipe system. A cable structure is wound on the pipe (2), whereby it is possible to indicate the conductance of the passing fluid on the basis of the characteristic impedance of the cable structure. As the pipe and the passing fluid form part of the cable structure, the characteristic impedance is dependent on the conductance of said passing fluid.

Fig.1

Fig.2

EP 0 502 807 A2

The invention relates to a device for measuring the conductance of a fluid, where the measuring member is a pipe of an insulating material and can be inserted, if desired, in an existing pipe system, one or more windings being wound on said pipe and being formed by a cable structure, which comprises a subjacent strip of dielectric material, a metal strip, an additional strip of dielectric material covering the metal strip, and a metal shielding covering the dielectric material.

When spreading liquid manure over an agricultural area, a demand often applies for a way of dosing said manure in response to the nutritious content of the agricultural area in question. Some agricultural areas contain less nutritious matter than other areas. Therefore it may be of interest to know the content of nutritious matter in the fluid to be spread. The content of nutritious matter can often be found merely by measuring the conductance of the fluid. The conductance can for instance be measured by means of electrodes inserted in a pipe for the fluid. These electrodes corrode, however, and are polluted, and accordingly such a solution is rather disadvantageous.

DE-PS No. 3,816,867 discloses a conductance measuring device in form of composite electrodes arranged about a pipe for a passing medium. Each composite electrode comprises a pin electrode and a surface electrode. The pin electrode is in direct contact with the passing medium with the result that it can corrode and cause formation of transition resistances.

It is also possible to measure the conductance of a liquid flowing through a pipe by means of a coil wound on said pipe, the conductance of the liquid having a minor effect on the inductance, cf. European Patent Application No. 306,792.

The object of the invention is to provide a device for measuring the conductance of a passing fluid, said device being less complicated than the known devices and not being in direct contact with the fluid.

A device of the above type is according to the invention characterised in that the cable structure is dimensioned so as to achieve a characteristic impedance, said structure being terminated by an impedance, preferably a resistor substantially corresponding to the approximate characteristic impedance of the cable structure. In this manner a device is obtained for measuring the conductance of a fluid, said device being substantially less complicated than the previously known devices.

The characteristic impedance may according to the invention be approximately 50 $\Omega$.

The invention relates furthermore to a method of measuring the conductance of a fluid, where the measuring member is a pipe of an insulating material and can be inserted, if desired, in an existing pipe system, one or more windings being wound on said pipe and being formed by a cable structure, which comprises a subjacent strip of dielectric material, a metal strip, an additional strip of dielectric material covering the metal strip, and a metal shielding covering the dielectric material. The method is according to the invention characterised in that the cable structure is dimensioned so as to achieve a characteristic impedance, said structure being terminated by an impedance, preferably a resistor substantially corresponding to the approximate characteristic impedance of the cable structure. The resulting method of measuring the conductance is particularly simple.

The invention is described in greater detail below with reference to the accompanying drawings, in which

Figure 1 illustrates a device according to the invention in form of a cable structure wound on a pipe for measuring the conductance of a passing fluid,

Figure 2 is a sectional view of the cable structure,

Figure 3 illustrates the three outer layers of the cable structure,

Figure 4 illustrates an associated measuring circuit,

Figure 5 illustrates a particularly advantageous emblodiment of the measuring circuit,

Figure 6 illustrates a transmission line corresponding to the cable structure, and

Figure 7 shows measurements of the reflection at and transmission through, respectively, the transmission line.

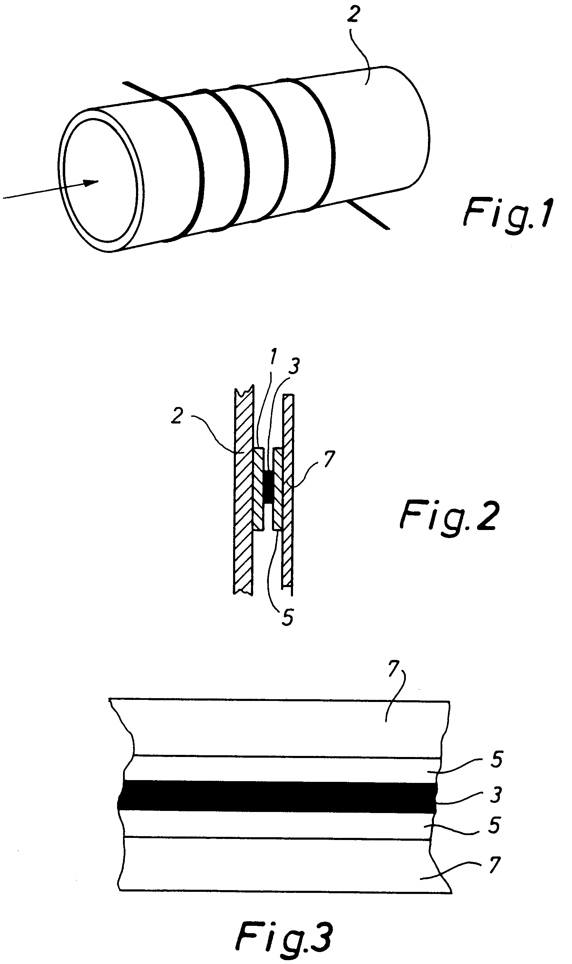

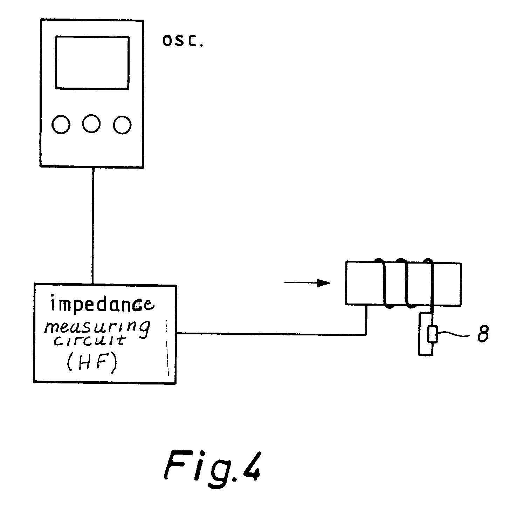

The device shown in Figure 1 for measuring the conductance of a fluid is formed by a pipe 2 of insulating material. The pipe can, if desired, be inserted in an existing pipe system. A cable structure is wound on the pipe 2, said cable structure comprising a subjacent strip 1 of dielectric material, cf. Figure 2, a metal strip 3 narrower compared to and arranged on said strip 1, and an additional strip 5 of dielectric material covering the metal strip 3. A metal shielding 7 is furthermore arranged above the dielectric strip 5, said shielding 7 being substantially broader than the dielectric strip 5. Figure 2 shows furthermore the pipe wall 2, on which the above layers are arranged. The cable structure is dimensioned to a characteristic impedance of approximately 50 $\Omega$ and is terminated by a resistor 8, cf. Figure 4, said resistor preferably also being of approximately 50 $\Omega$.

The pipe 2 is made of an insulating material. The principle of the invention is therefore that the passing fluid forms the second half of the (metal) shielding of the cable structure. The characteristic impedance of the cable structure depends therefore on the conductance of the passing fluid.

The dielectric constant and the loss factor of the pipe 2 effect, however, the measured conductance, and accordingly it is important that the loss factor is as low as possible.

The pipe 2 in question need only be inserted in the pipe system in question. The cable structure can also be wound directly on existing pipes of insulating material. The determination of a calibration curve necessitates only two sets of associated values of conductance of the fluid and impedance of the cable structure, said calibration curve being assumed to be linear.

If desired, an outer metal pipe can be employed in order to prevent radiation into the system.

Figure 4 illustrates the entire measuring system. In addition to the cable structure wound on the pipe 2 and acting as a transmission line, the system includes an impedance measuring circuit 9 communicating with the cable structure optionally through a conventional coaxial cable. The impedance can, if desired, be indicated on an oscilloscope communicating with the impedance measuring circuit 9.

The cable structure must, of course, be substantially longer than the wave length at the signal frequency in question, said frequency preferably being in the HF-range.

A particular advantage of the measuring system according to the invention is that it can be moved without difficulty, provided the pipes in question are known. Such a moving requires nothing but a calibration curve corresponding to the pipes. The cable structure need not be arranged particularly accurately and can for instance be glued onto the pipe.

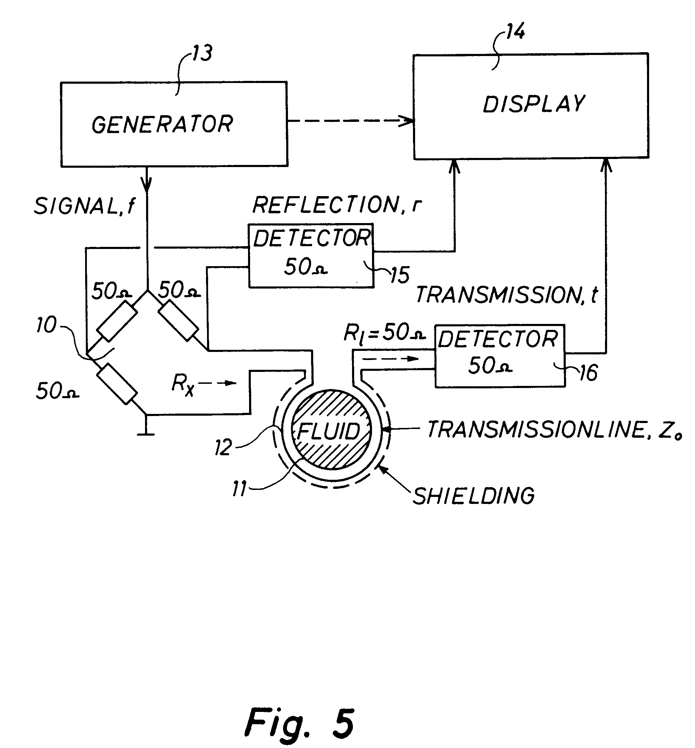

Figure 5 illustrates a particularly advantageous embodiment of the measuring circuit. The measuring circuit of this embodiment comprises a bridge coupling 10, one branch of said bridge coupling being formed by a cable structure in form of a transmission line 12. The three remaining branches are formed by a resistor of 50 Ω. The transmission line 12 is wound on a cylindrical measuring chamber 11 containing the fluid, the conductance of which is to be measured. The transmission line 12 is terminated by a resistor of 50 Ω. A generator 13 generates a signal of a frequency of 218 MHz or 431 MHz to the bridge coupling 10. Then the signal reflected at the transmission line 12 is detected as the bridge voltage in a detector 15 across a resistor of 50 Ω. The detected and smoothed bridge voltage is transmitted to a display 14 indicating the reflection r. In addition, the signal across the resistor in a detector 16 at the end of the transmission line 12 is detected. The detected and smoothed signal from the detector 16 indicates the transmission t. This signal is also transferred to the display 14 with the result that both the reflection r and the transmission t are presented for the fluid in question at the frequency in question. Now it is possible to find the conductance of the fluid on the basis of predetermined calibration curves, whereby it is utilized that an unambigous relationship exists between the conductance and the reflection/transmission. Some fluids provide the most accurate result at one frequency and by way of a measurement of the reflection, whereas other fluids are more accurately measured at the other frequency and by way of a measurement of the transmission.

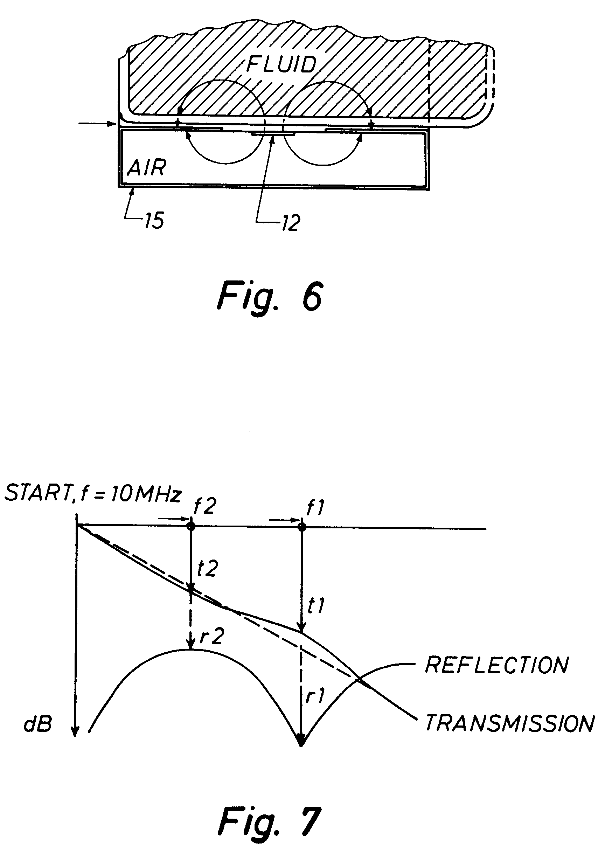

Figure 6 illustrates an example of a transmission line 12 around the cylindrical container with the fluid to be measured. The transmission line 12 is formed by a copper strip of a width of 5 mm and a length of 170 mm. The dielectric material of the container between the fluid and the transmission line 12 presents in the illustrated example a relative dielectric constant of approximately 2.2. The transmission line 12 is surrounded by a shielding 15.

Figure 7 illustrates the reflection r and the transmission t versus the frequency. The reflection r dives at some frequencies in response to the length of the transmission line 12, whereas the transmission t decreases gradually with the frequency.

## Claims

1. A device for measuring the conductance of a fluid, where the measuring member is a pipe (2) of an insulating material and can be inserted, if desired, in an existing pipe system, one or more windings being wound on said pipe (2) and being formed by a cable structure, which comprises a subjacent strip (1) of dielectric material, a metal strip (3), an additional strip (5) of dielectric material covering the metal strip (3), and a metal shielding (7) covering the dielectric material, characterised in that the cable structure is dimensioned so as to achieve a characteristic impedance, said structure being terminated by an impedance, preferably a resistor (8) substantially corresponding to the approximate characteristic impedance of the cable structure.

2. A device as claimed in claim 1, characterised by the characteristic impedance being approximately 50 Ω.

3. A method of measuring the conductance of a fluid, where the measuring member is a pipe (2) of an insulating material and can be inserted, if desired, in an existing pipe system, one or more windings being wound on said pipe (2) and being formed by a cable structure, which comprises a subjacent strip (1) of dielectric material, a metal strip (3), an additional strip (5) of dielectric material covering the metal strip (3), and a metal shielding (7) covering the dielectric material, characterised in that the cable structure is dimensioned so as to achieve a characteristic impedance, said structure being terminated by an impedance, preferably a resistor (8) substantially corresponding to the approximate characteristic impedance of the cable structure.

4. A method as claimed in claim 3, characterised in that the cable structure is dimensioned so as to achieve a characteristic impedance of 50 Ω, and is terminated by a resistor of approximately 50 Ω.

Fig.1

Fig.2

Fig.3

EP 0 502 807 A2

osc.

impedance
measuring
circuit
(HF)

8

# Fig.4

6

**Fig. 5**

Fig. 6

Fig. 7